(19) **Europäisches Patentamt / European Patent Office / Office européen des brevets**

(11) **EP 2 827 544 B1**

(12) **EUROPÄISCHE PATENTSCHRIFT**

(45) Veröffentlichungstag und Bekanntmachung des Hinweises auf die Patenterteilung:
**27.03.2019  Patentblatt 2019/13**

(51) Int Cl.:
*H04L 25/02* (2006.01)          *H04L 25/03* (2006.01)
*H03M 13/45* (2006.01)          *H03M 13/00* (2006.01)

(21) Anmeldenummer: **14002367.2**

(22) Anmeldetag: **10.07.2014**

(54) **Datenübertragungsverfahren für Kanäle mit schnellveränderlichen Übertragungseigenschaften**

Data transmission method for channels with rapidly changing transmission characteristics

Procédé de transmission de données pour canaux ayant des propriétés de transmission changeant rapidement

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.07.2013   DE 102013011914**

(43) Veröffentlichungstag der Anmeldung:
**21.01.2015   Patentblatt 2015/04**

(73) Patentinhaber: **MBDA Deutschland GmbH
86529 Schrobenhausen (DE)**

(72) Erfinder:
• **Lewandowsky, Jan Christopher
  D-42279 Wuppertal (DE)**
• **Ludwig, Stephan
  D-73061 Ebersbach / Fils (DE)**
• **Lankl, Berthold
  D-85658 Egmating (DE)**
• **Thienel, Martin
  D-82024 Taufkirchen (DE)**

(74) Vertreter: **Isarpatent et al
Patent- und Rechtsanwälte Behnisch Barth Charles
Hassa Peckmann & Partner mbB
Friedrichstrasse 31
80801 München (DE)**

(56) Entgegenhaltungen:
**US-A1- 2003 099 308**

• **LEWANDOWSKY JAN ET AL: "Detection by Inherent Channel Estimation in rapidly fading channels", 2013, 7TH INTERNATIONAL CONFERENCE ON SIGNAL PROCESSING AND COMMUNICATION SYSTEMS (ICSPCS), IEEE, 16. Dezember 2013 (2013-12-16), Seiten 1-5, XP032555458, DOI: 10.1109/ICSPCS.2013.6723909 [gefunden am 2014-01-24]**
• **KUBO H ET AL: "A generalization of multiple-symbol differential detection and its application to fast time-varying fading channels", VTC 2003-SPRING. THE 57TH. IEEE SEMIANNUAL VEHICULAR TECHNOLOGY CONFERENCE. PROCEEDINGS. JEJU, KOREA, APRIL 22 - 25, 2003; [IEEE VEHICULAR TECHNOLGY CONFERENCE], NEW YORK, NY : IEEE, US, Bd. 4, 22. April 2003 (2003-04-22), Seiten 2353-2357, XP010862269, DOI: 10.1109/VETECS.2003.1208810 ISBN: 978-0-7803-7757-8**

EP 2 827 544 B1

**Beschreibung**

**Technisches Gebiet der Erfindung**

Die Erfindung betrifft ein Datenübertragungsverfahren und ein das Datenübertragungsverfahren nutzendes Datenübertragungssystem sowie einen unbemannten Flugkörper mit einer Empfangseinheit, welche das Datenübertragungsverfahren implementiert. Insbesondere betrifft die Erfindung ein Verfahren zum Ermitteln einer Auswahlmetrik für eine Auswahl einer Zeichenfolge aus einer Mehrzahl von zulässigen Zeichenfolgen eines Zeichenfolgenalphabets.

**Hintergrund der Erfindung**

Zur Übertragung von Daten zwischen einer Quelle und einer Senke bzw. zwischen einem Sender und einem Empfänger werden die zu übertragenden Symbole, welche die zu übertragenden Daten darstellen, üblicherweise in eine maschinell handhabbare Zeichenfolge umgesetzt, bevor diese Zeichenfolge von der Quelle zu der Senke übertragen wird.

Im Bereich des Empfängers kann eine Überprüfung auf Übertragungsfehler der Zeichenfolge und teilweise in beschränktem Umfang sogar eine Korrektur von Übertragungsfehlern erfolgen.

Üblicherweise sind Empfangs- oder Detektionsverfahren darauf beschränkt, Fehler, die auf einer einzelnen bekannten Störquelle bzw. auf einer einzelnen bekannten Wirkung einer Störquelle auf dem zwischen Quelle und Senke befindlichen Übertragungskanal basieren, zu behandeln.

Als Störquelle ist in diesem Zusammenhang jegliche Wirkung zu verstehen, die ein übertragenes Signal auf dessen Weg von der Quelle zur Senke verfälscht oder verändert, so dass eine Erkennung des ursprünglich gesendeten Signals auf Seiten der Senke fehlerhaft sein kann. Insbesondere kann als Störquelle ein elektromagnetisches Feld, Rauschen, Mehrwegausbreitung und Signalüberlagerung angesehen werden.

Einfache Fehlerfeststellungsverfahren und Fehlerkorrekturverfahren können beispielsweise darauf beschränkt sein, die Einflüsse einer einzelnen Quelle auf ein übertragenes Signal zu erkennen und/oder zu beseitigen.

Komplexe Empfangs- oder Detektionsverfahren können auch dafür ausgelegt sein, solche Fehler zu behandeln, welche auf Grund von im Vorhinein unbekannter und mehrfacher Störquellen auftreten. Solche komplexen Empfangs- oder Detektionsverfahren sind jedoch teilweise praktisch nicht oder nur schwer umsetzbar und erfordern einen hohen Aufwand zum Ausführen in einem Empfänger. Damit kann insbesondere die erreichbare Datenrate nur sehr gering sein, da diese im Wesentlichen von der Ausführungszeit des Empfangs- oder Detektionsverfahrens vorgegeben wird.

Ein optimales Empfangsverfahren ist für den Spezialfall eines Kanals mit gaußverteilter Störung (ein sog. Rice-Kanal) bekannt, wenn zusätzlich zur Wahrscheinlichkeitsverteilung der Kanalkoeffizienten die Momente erster und zweiter Ordnung bekannt sind [van Trees: "Detection, Estimation, and Modulation Theory, Part III, Radar-Sonar Signal Processing and Gaussian Signals in Noise", John Wiley & Sons, 2004]. Das vorgestellte Verfahren ist allgemeingültig für Kanäle beliebiger Wahrscheinlichkeitsverteilung und benötigt keine Kenntnis derer Momente.

EP 2 296 288 B1 beschreibt ein Übertragungssystem und ein Übertragungsverfahren zum Übertragen von modulierten binären Signalen in mobilen Kommunikationssystemen. Dabei wird ein Verfahren zum Ermitteln einer Auswahlmetrik für eine Auswahl einer Zeichenfolge aus einer Mehrzahl von zulässigen Zeichenfolgen beschrieben. Diese Auswahl erfolgt basierend auf einer über einen Übertragungskanal empfangenen Zeichenfolge.

US 2004/0066865 A1 beschreibt eine Kommunikationsvorrichtung zum Erkennen von Impulsrauschen in einer Präambel eines übertragenen Signalmusters. Die Präambel dient der Ermittlung von Kanalparametern und umfasst eine Mehrzahl von Symbolen, welche nach dem Empfang durch zumindest ein bekanntes Präambelsymbol geteilt werden um eine Mehrzahl von Werten zu erhalten, die den Präambelsymbolen entsprechen. Abschließend ermittelt die Kommunikationsvorrichtung basierend auf der Mehrzahl von Werten ob ein Präambelsymbol durch Impulsrauschen beeinflusst wurde.

US 2003/099308 A1 beschreibt ein Verfahren und ein System für die Kanalschätzung und Signalerfassung in einem Kommunikationssystem, das mehrere Kanäle zum Übertragen von Symbolen umfasst. Die Mehrzahl von Kanälen wird geschätzt indem eine geringe Anzahl an ursprünglich empfangenen Symbolen für die Schätzung genutzt wird. Im Anschluss an die Schätzung wird der beste Kanal ausgewählt. Die weitere Übertragung erfolgt über den besten Kanal, welcher laufend angepasst werden kann.

**Zusammenfassung der Erfindung**

Es kann als eine Aufgabe der Erfindung betrachtet werden, ein Datenübertragungsverfahren mit geringer Komplexität und geringem Ausführungsaufwand für Kanäle mit einer Mehrzahl unterschiedlicher Störeinflüsse auf die übertragenen Daten und ein Datenübertragungssystem, welches ein solches Datenübertragungsverfahren nutzt, bereitzustellen.

Die Aufgabe wird gelöst durch die Merkmale der unabhängigen Patentansprüche. Weiterbildungen der Erfindung ergeben sich aus den abhängigen Patentansprüchen und aus der folgenden Beschreibung.

Die Ausführungen in der folgenden Beschreibung gelten sinngemäß gleich für das Verfahren wie auch für das Datenübertragungssystem, welches das Verfahren implementiert.

Gemäß einem ersten Aspekt ist ein Verfahren zum Ermitteln einer Auswahlmetrik für eine Auswahl einer Zeichenfolge aus einer Mehrzahl zulässiger Zeichenfolgen eines Zeichenfolgenalphabets basierend auf einer über einen Übertragungskanal empfangenen Zeichenfolge angegeben, wobei die Mehrzahl zulässiger Zeichenfolgen durch ein Zeichenfolgenalphabet vorgegeben ist und jede Zeichenfolge eine Mehrzahl N von Informationseinheiten aufweist. Das Verfahren weist dabei folgende Schritte auf: Ermitteln jeweils einer hypothetischen Kanalfolge basierend auf der empfangenen Zeichenfolge und jeder Zeichenfolge der Mehrzahl zulässiger Zeichenfolgen aus dem Zeichenfolgenalphabet, wobei die hypothetische Kanalfolge eine Mehrzahl N von hypothetischen Kanalkoeffizienten aufweist, die jeweils einer Informationseinheit zugeordnet sind; Ermitteln der Auswahlmetrik für jede hypothetische Kanalfolge als Summe der Beträge der Differenz jeweils zweier aufeinanderfolgender hypothetischer Kanalkoeffizienten einer hypothetischen Kanalfolge.

Eine Zeichenfolge wird dabei von einer Anzahl von Informationseinheiten gebildet, die beispielsweise als binäre, tertiäre oder mehrstufige Signale übertragen werden können. Eine Zeichenfolge entspricht einem Symbol, wobei die Zuordnung zwischen Symbol und zugehöriger Zeichenfolge eineindeutig ist, d.h. ein Symbol entspricht genau einer Zeichenfolge und diese Zeichenfolge entspricht weiterhin auch nur genau diesem Symbol.

Das Zeichenfolgenalphabet bildet die abgeschlossene Menge nutzbarer Symbole und entsprechend zugeordneter Zeichenfolgen ab.

Die in dem Zeichenfolgenalphabet enthaltenen Zeichenfolgen werden als zulässige Zeichenfolgen bezeichnet, wohingegen die Gesamtzahl aller möglichen Zeichenfolgen basierend auf der Anzahl der Signalstufen einer Informationseinheit und der Anzahl von Informationseinheiten in einer Zeichenfolge ermittelt wird. Enthält eine Zeichenfolge beispielsweise acht Informationseinheiten, welche jeweils zwei Zustände einnehmen können, also zweistufig sind, sind insgesamt 256 ($=2^8$) verschiedene Zeichenfolgen darstellbar, also möglich. Sind aus dieser Gesamtmenge von 256 möglichen Zeichenfolgen 30 vergeben, weil ein Bedarf von 30 verschiedenen zu übertragenden Symbolen besteht, dann werden diese 30 Symbole 30 verschiedenen Zeichenfolgen aus der Gesamtmenge aller möglichen Zeichenfolgen zugeordnet und bilden die Menge der zulässigen Zeichenfolgen. Die einzelnen Informationseinheiten der empfangenen Zeichenfolge können als reelle oder komplexe Zahlen abgebildet und verarbeitet werden.

Die Übertragung kann über einen beliebigen Übertragungskanal erfolgen, d.h. leitungsgebunden, z.B. über elektrische oder optische Signale, oder leitungslos, z.B. über Funkstrecken mittels elektromagnetischer Wellen oder über optische Signale mittels Laser oder Infrarotlicht. Der Übertragungskanal kann zwischen zueinander beweglichen Sendern und Empfängern angeordnet sein und insbesondere eine hohe Dopplerfrequenz aufweisen, beispielsweise weil sich die zueinander beweglichen Sender/Empfänger mit einer hohen Relativgeschwindigkeit bewegen, beispielsweise mit mehreren Hundert oder sogar mehreren Tausend Kilometern pro Stunde. In einem solchen Szenario kann es auf dem Übertragungskanal zu schnell wechselnden Empfangsfeldstärken kommen, welche die Empfangsqualität ebenfalls negativ beeinflussen können.

Grundsätzlich kennt der Empfänger die von einem Sender gesendete Zeichenfolge nicht, sondern muss die gesendete Zeichenfolge aus der empfangenen Zeichenfolge rekonstruieren bzw. ermitteln. Dieses Rekonstruieren der gesendeten Zeichenfolge kann erschwert werden, wenn auf dem Übertragungskanal Störeinflüsse auf die gesendete Zeichenfolge wirken und diese verändern oder verfälschen.

Die mit dem wie oben und im Folgenden beschriebenen Verfahren ermittelte Auswahlmetrik ermöglicht eine Auswahl der plausibelsten Zeichenfolge aus dem Zeichenfolgenalphabet basierend auf der tatsächlich empfangenen Zeichenfolge. In anderen Worten ermöglicht die Auswahlmetrik die Auswahl eines Symbols aus dem Alphabet, welches für eine möglicherweise verfälscht und ggf. unbekannter weise durch eine oder mehrere verschiedene Störeinflüsse verfälscht empfangene Zeichenfolge die plausibelste Wahl darstellt.

Die Störeinflüsse eines jeden Übertragungskanals lassen sich mittels einer Übertragungsfunktion bzw. einer Kanalfolge beschreiben. Die Kanalfolge verändert bei einer Übertragung einer Zeichenfolge über den Übertragungskanal die Zeichenfolge und führt so zu der veränderten durch den Empfänger empfangenen Zeichenfolge. Bei bekannter Kanalfolge ist somit die veränderte empfangene Zeichenfolge in die gesendete Zeichenfolge umrechenbar.

Das erfindungsgemäße Verfahren ermöglicht im Gegensatz dazu eine Ermittlung einer Auswahlmetrik für empfangene Zeichenfolgen über einen Übertragungskanal mit einer unbekannten und mehrparametrigen, d.h. aus mehreren Störquellentypen bestehenden Kanalfolge.

Die Kanalfolge weist eine Mehrzahl von Kanalkoeffizienten auf, von denen jeweils einer auf eine Informationseinheit einer übertragenen Zeichenfolge wirkt. Aufeinanderfolgende Kanalkoeffizienten sind dabei zeitlich aufeinanderfolgenden Informationseinheiten einer übertragenen Zeichenfolge zugeordnet. Bei einer Zeichenfolgenlänge von acht Informationseinheiten hat die Kanalfolge entsprechend acht Kanalkoeffizienten.

Das Verfahren zur Ermittlung der Auswahlmetrik einer empfangenen Zeichenfolge macht sich die Erkenntnis zu Nutze, dass die aufeinanderfolgenden Kanalkoeffizienten einer Kanalfolge in einem Zahlenraum, beispielsweise in einem kartesischen Koordinatensystem aus reellen Zahlen oder in einem Koordinatensystem, das den Real- und Imaginärteil einer komplexen Zahl abbildet, einem stetigen Verlauf folgen und, wenn diese mittels eines Graphen verbunden werden, dieser Graph für Kanalfolgen tatsächlich existierender Übertragungskanäle die kürzest mögliche Länge haben. Bei dieser Erkenntnis handelt es sich um eine Grundannahme für das oben und im Folgenden beschriebene Verfahren, da die Änderung eines Kanals und somit seiner Kanalkoeffizienten nicht beliebig schnell erfolgt.

Basierend auf der Erkenntnis dass die Kanalfolgen existierender Übertragungskanäle diesen geringsten akkumulierten Abstand zwischen jeweils zwei aufeinanderfolgenden Kanalkoeffizienten hat, kann somit die Entscheidung getroffen werden, welche Zeichenfolge aus der Menge der zulässigen Zeichenfolge ausgehend von einer empfangenen Zeichenfolge diejenige hypothetische Kanalfolge aufweist, die der genannten Bedingung genügt.

Dazu wird für jede paarweise Kombination aus der empfangenen Zeichenfolge und jeder zulässigen Zeichenfolge eine hypothetische Kanalfolge mit ihren Kanalkoeffizienten ermittelt. In anderen Worten erfolgt ein Vergleich der empfangene Zeichenfolge mit jeder der zulässigen Zeichenfolgen.

Für jede so ermittelte hypothetische Kanalfolge wird die Auswahlmetrik wie folgt ermittelt: zunächst wird eine erste Differenz zwischen dem ersten und zweiten Kanalkoeffizienten gebildet, anschließend eine zweite Differenz zwischen dem zweiten und dritten Kanalkoeffizienten bis hin zu einer letzten Differenz zwischen dem vorletzten und dem letzten Kanalkoeffizienten. Die Summe dieser Differenzen für eine hypothetische Kanalfolge entspricht der Länge eines Graphen, der aufeinanderfolgende Kanalkoeffizienten in einem Zahlenraum miteinander verbindet. Weiterhin ist diese Summe die Auswahlmetrik für die Auswahl einer Zeichenfolge aus der Menge der zulässigen Zeichenfolgen, wobei diejenige Zeichenfolge ausgewählt wird, deren Auswahlmetrik den niedrigsten Betrag hat, also deren die Kanalkoeffizienten verbindender Graph die geringste Länge hat.

Eine von einem Sender über einen Übertragungskanal gesendete und von einem Empfänger empfangene Zeichenfolge wird durch die Kanalfolge verändert. Das erfindungsgemäße Verfahren ermittelt auf Seiten des Empfängers in Unkenntnis der tatsächlich gesendeten Zeichenfolge für jede mögliche Zeichenfolge, also für jede gemäß dem Zeichenfolgenalphabet zulässige Zeichenfolge eine hypothetische Kanalfolge, für die sodann an Hand der Kanalkoeffizienten untersucht wird, ob sie tatsächlich auf Grund ihrer Form einer realen Kanalfolge entsprechen könnte, wobei der Parameter, an Hand dessen hierüber entschieden wird, der Abstand der dargestellten Kanalkoeffizienten ist. Je geringer dieser Abstand, desto eher handelt es sich bei der entsprechenden Kanalfolge um eine Kanalfolge eines tatsächlichen Übertragungskanals, also umso eher entspricht die dieser Auswahlmetrik zugeordnete zulässige Zeichenfolge der tatsächlich gesendeten Zeichenfolge.

Im Umkehrschluss ergibt sich bei Ermittlung der hypothetischen Kanalfolge für eine empfangene Zeichenfolge und einer nicht gesendeten zulässigen Zeichenfolge eine Kanalfolge, deren aufeinanderfolgende Kanalkoeffizienten einen unregelmäßigen Verlauf in einem Zahlenraum aufweisen und so zu einem erhöhten akkumulierten Abstand zwischen den Kanalkoeffizienten führen.

Damit wird ein Verfahren zum Ermitteln einer Auswahlmetrik für die Auswahl einer Zeichenfolge aus einer Mehrzahl zulässiger Zeichenfolgen basierend auf einer empfangenden Zeichenfolge bereitgestellt, das bei Unkenntnis über die Übertragungseigenschaften eines Kanals, also dessen Kanalfolge, eine Auswahl aus dem zur Verfügung stehenden Zeichenfolgenalphabet ermöglicht, wobei der Übertragungskanal gerade eine Mehrzahl sich überlagernder Störquellen aufweisen kann. Das Verfahren zeichnet sich insbesondere durch eine geringe Komplexität und einen geringen Rechenaufwand aus, der auf Seiten einer Empfangseinheit für die Durchführung des Verfahrens bereitgestellt werden muss.

Gemäß einer Ausführungsform wird die Auswahlmetrik über lediglich einen Teil der Kanalkoeffizienten einer Kanalfolge ermittelt, beispielsweise über die erste Hälfte oder über die letzte Hälfte der Kanalkoeffizienten.

Diese Ausführungsform kann insbesondere eine noch schnellere Ausführung ermöglichen, da der Rechenaufwand bzw. die Rechenzeit für ihre Abarbeitung noch weiter reduziert werden kann.

Gemäß einer weiteren Ausführungsform wird die Auswahlmetrik als Summe der Differenz jeweils zweier aufeinanderfolgender hypothetischer Kanalkoeffizienten einer hypothetischen Kanalfolge über alle hypothetischer Kanalkoeffizienten dieser hypothetischen Kanalfolge ermittelt wird.

Diese Ausführungsform kann eine genauere Auswahlmetrik liefern, da mehr Kanalkoeffizienten bei deren Berechnung berücksichtigt werden.

Der Vollständigkeit halber sei darauf hingewiesen, dass in einer Ausführungsform von den Kanalkoeffizienten mindestens zwei für die Berechnung der Auswahlmetrik herangezogen werden, wobei die Anzahl der für die Berechnung der Auswahlmetrik herangezogenen Kanalkoeffizienten um jeweils eins bis hin zur Gesamtzahl der Kanalkoeffizienten steigen kann. Die Bestimmung der für die Berechnung der Auswahlmetrik tatsächlich herangezogenen Anzahl von Kanalkoeffizienten kann als Abwägung zwischen Genauigkeit (höhere Anzahl) oder Rechenzeit (geringere Anzahl) betrachtet werden.

Gemäß einer weiteren Ausführungsform wird die Zeichenfolge aus der Mehrzahl zulässiger Zeichenfolgen aus dem Zeichenfolgenalphabet ausgewählt wird, deren Auswahlmetrik den geringsten Betrag aufweist.

Wie bereits weiter oben dargelegt, handelt es sich hierbei um die Wahl derjenigen Zeichenfolge, deren berechnete hypothetische Kanalfolge in ihrer grundsätzlichen Darstellung und in ihrem grundsätzlichen Verlauf in einem Zahlenraum einer tatsächlich bestehenden Kanalfolge am meisten ähnelt.

Gemäß einer weiteren Ausführungsform weist das Verfahren weiterhin den Schritt auf: Festlegen der zulässigen Zeichenfolgen des Zeichenfolgenalphabets, wobei eine Anzahl der zulässigen Zeichenfolgen kleiner ist als eine Anzahl aller möglichen Zeichenfolgen basierend auf der Mehrzahl N von Informationseinheiten einer Zeichenfolge.

Um in dem obigen Beispiel zu bleiben: bei acht Informationseinheiten ergeben sich 256 mögliche Zeichenfolgen. Werden diese auch alle verwendet, gibt es immer eine Zeichenfolge, die sich von einer anderen Zeichenfolge in dem Wert nur einer einzelnen Informationseinheit unterscheidet. In anderen Worten beträgt die Hamming-Distanz dieser beiden Zeichenfolgen eins.

Gemäß einer weiteren Ausführungsform kann für die Ermittlung der Hamming-Distanz eine differentiell decodierte Zeichenfolge basierend auf einer der möglichen bzw. zulässigen Zeichenfolgen herangezogen werden anstatt direkt die möglichen Zeichenfolgen heranzuziehen.

Die differentiell decodierte Zeichenfolge gibt an, ob sich der Wert benachbarter Informationseinheiten in einer zulässigen Zeichenfolge ändert; somit enthält die differentiell decodierte Zeichenfolge Informationen über die Beziehung jeweils zwei benachbarter Informationseinheiten in einer zulässigen Zeichenfolge zueinander.

Es liegt auf der Hand, dass bei einer solchen Konstellation die Auswahlmetrik der hypothetischen Kanalfolge für sich in wenigen Informationseinheiten unterscheidende Zeichenfolgen einen ähnlichen Wert annehmen kann. Diese Konstellation könnte die Entscheidung für und gegen eine der zulässigen Zeichenfolgen erschweren, da die Auswahlmetriken der entsprechenden hypothetischen Kanalfolgen einen ähnlichen Wert annehmen können.

Damit gilt, dass die Auswahlmetrik ein umso zuverlässigerer Indikator für eine zulässige Zeichenfolge darstellt, je höher die Hamming-Distanz zwischen den zulässigen Zeichenfolgen ist. Im Extremfall kann die Hamming-Distanz bei acht Informationseinheiten und lediglich zwei zulässigen Zeichenfolgen acht sein, da die beiden Zeichenfolgen so gewählt werden können, dass sie sich in allen acht Informationseinheiten unterscheiden können. Mit jeder zusätzlichen zulässigen Zeichenfolge kann dann die paarweise Hamming-Distanz zwischen diesen nur noch abnehmen. Die paarweise Hamming-Distanz wird als Hamming-Distanz zwischen jeder zulässigen Zeichenfolge und jeder anderen zulässigen Zeichenfolge ermittelt.

Gemäß einer weiteren Ausführungsform ist die Anzahl der zulässigen Zeichenfolgen kleiner als $2^N$, wobei $2^N$ der Anzahl aller möglichen Zeichenfolgen bei N Informationseinheiten entspricht, wenn jede Informationseinheit zwei Zustände einnehmen kann.

Gemäß einer weiteren Ausführungsform ist die Anzahl der zulässigen Zeichenfolgen kleiner als die Hälfte der Anzahl aller möglichen Zeichenfolgen.

Gemäß einem weiteren Aspekt ist ein Datenübertragungssystem mit einer Sendeeinheit und einer Empfangseinheit angegeben, wobei die Empfangseinheit ein erstes Empfangsmodul aufweist und wobei die Sendeeinheit ausgeführt ist, Daten über einen Übertragungskanal mit unbekannten Übertragungseigenschaften an die Empfangseinheit zu übertragen. Das erste Empfangsmodul ist ausgeführt, das Verfahren wie oben und im Folgenden beschrieben zum Ermitteln einer ersten Auswahlmetrik auszuführen. Die Empfangseinheit ist ausgeführt, eine Auswahl von Zeichenfolgen aus einer Mehrzahl zulässiger Zeichenfolgen basierend auf Zeichenfolgen der übertragenen Daten und auf der ersten Auswahlmetrik zu treffen.

Das erste Empfangsmodul empfängt die Zeichenfolgen der übertragen Daten und ermitteln sodann für die empfangenen Zeichenfolgen basierend auf deren hypothetischen Kanalfolgen zu jeder zulässigen Zeichenfolge die Auswahlmetrik. Die Auswahlmetrik wird anschließend an die Empfangseinheit übermitteln, welche ausgehend von der Auswahlmetrik die Auswahl einer zulässigen Zeichenfolge aus der Mehrzahl zulässiger Zeichenfolgen, also aus dem zulässigen Zeichenfolgenalphabet, trifft.

Gemäß einer Ausführungsform weist die Empfangseinheit ein zweites Empfangsmodul auf, wobei das zweite Empfangsmodul ausgeführt ist, das Verfahren wie oben und im Folgenden beschrieben zum Ermitteln einer zweiten Auswahlmetrik auszuführen, wobei die Empfangseinheit ausgeführt ist, eine Auswahl von Zeichenfolgen aus einer Mehrzahl zulässiger Zeichenfolgen basierend auf Zeichenfolgen der übertragenen Daten und auf der ersten Auswahlmetrik und der zweiten Auswahlmetrik zu treffen.

Sowohl das erste Empfangsmodul als auch das zweite Empfangsmodul ermitteln damit unabhängig voneinander eine Auswahlmetrik für eine jeweils von ihnen gleichzeitig empfangene Zeichenfolge, wobei diese Zeichenfolge, für die beide Empfangsmodule die Auswahlmetrik unabhängig voneinander ermitteln, derselben gesendeten Zeichenfolge entspricht. Es sei darauf hingewiesen, dass die selbe gesendete Zeichenfolge durch die beiden Empfangsmodule anders empfangen werden kann, da die gesendete Zeichenfolge auf dem Weg zu den jeweiligen Empfangsmodulen unterschiedlichen Störeinflüssen ausgesetzt sein kann. In anderen Worten entspricht also dieselbe gesendete Zeichenfolge auf Grund unterschiedlicher Übertragungseigenschaften zu den Empfangsmodulen unterschiedlichen empfangenen Zeichenfolgen.

Die Empfangseinheit wiederum kann die Auswahl einer Zeichenfolge aus der Mehrzahl zulässiger Zeichenfolgen beispielsweise basierend auf einer Summe oder auf einem Durchschnittswert der ersten und zweiten Auswahlmetrik treffen.

Durch diesen Aufbau kann eine verbesserte Auswahl einer zulässigen Zeichenfolge erfolgen, da beispielsweise die von den Empfangsmodulen jeweils empfangene Zeichenfolge unterschiedliche Wege über den Übertragungskanal zurückgelegt haben und einer anderen Kanalfolge ausgesetzt worden sein kann. Indem zwei Empfangsmodule unabhängig voneinander die Auswahlmetrik für die selbe gesendete Zeichenfolge ermitteln, wird eine höhere Zuverlässigkeit der ausgewählten Zeichenfolge ermöglicht.

Das erste und zweite Empfangsmodul können räumlich voneinander getrennt sein, d.h. im einfachsten Fall, dass sie räumlich voneinander beabstandet sind. Alternativ oder zusätzlich können die beiden Empfangsmodule beispielsweise auch in getrennten Gehäusen angeordnet sein oder auch unterschiedliche Übertragungskanäle mit unterschiedlichen Übertragungsmedien nutzen. Gerade unterschiedlich ausgeführte Empfangsmodule können die Zuverlässigkeit der ermittelten Auswahlmetrik erhöhen, da die Zeichenfolgen über mehrere Übertragungskanäle empfangen werden und so die Auswirkungen unterschiedlicher Störungsquellen erkannt werden können.

Das Datenübertragungssystem kann selbstverständlich auch mehr als zwei Empfangsmodule aufweisen, wobei mit zunehmender Anzahl von Empfangsmodulen, die das Verfahren zur Ermittlung der Auswahlmetrik unabhängig voneinander ausführen die Zuverlässigkeit der ermittelten Auswahlmetrik grundsätzlich steigt.

Die Empfangseinheit kann in einer Ausführungsform als sog. Rake-Empfänger mit mehreren Empfangspfaden ausgeführt sein.

Gemäß einer weiteren Ausführungsform findet zwischen der Sendeeinheit und der Empfangseinheit eine Relativbewegung statt.

Durch die Bewegung mindestens der Sendeeinheit oder der Empfangseinheit oder beiden tritt üblicherweise zusätzlich zu anderen Störungsquellen auch noch ein Dopplereffekt hinzu, insbesondere bei Datenübertragung über elektromagnetische Wellen, der eine gesendete Zeichenfolge verfälschen kann.

Gemäß einem weiteren Aspekt ist ein unbemannter Flugkörper mit einer Empfangseinheit angegeben. Die Empfangseinheit weist zumindest ein Empfangsmodul auf, welches ausgeführt ist, über einen Übertragungskanal Daten von einer Sendeeinheit zu empfangen, wobei das zumindest eine Empfangsmodul ausgeführt ist, das Verfahren wie oben und im Folgenden beschrieben auszuführen.

Bei dem unbemannten Flugkörper kann es sich beispielsweise um einen Lenkflugkörper handeln, der über die Empfangseinheit Betriebsdaten empfängt, wie z.B. Steuerkommandos. Durch die hohe Geschwindigkeit eines Lenkflugkörpers können die übertragenen Daten einem Störeinfluss aus mehreren wechselnden und im Voraus unbekannten und variierenden Störquellen ausgesetzt sein.

Gerade in einem solchen Szenario kann das von der Empfangseinheit ausgeführte Verfahren zum Ermitteln einer Auswahlmetrik für die Auswahl einer Zeichenfolge aus einem Zeichenfolgenalphabet zulässiger Zeichenfolgen vorteilhaft sein, da es auf Grund seiner geringen Komplexität eine wenig aufwändige Bestimmung und Auswahl einer zulässigen Zeichenfolge ermöglicht.

Wie bereits im Zusammenhang mit dem Datenübertragungssystem beschrieben, kann der unbemannte Flugkörper auch eine Empfangseinheit mit mehreren Empfangsmodulen aufweisen, welche in einer Ausführungsform räumlich getrennt in oder an dem unbemannten Flugkörper angeordnet sind.

## Kurze Beschreibung der Zeichnungen

Nachfolgend wird anhand der beigefügten Zeichnungen näher auf Ausführungsbeispiele der Erfindung eingegangen. Es zeigen:

Fig. 1   ein Zeichenfolgenalphabet für ein Verfahren gemäß einem Ausführungsbeispiel.

Fig. 2   ein Modell eines Übertragungskanals eines Datenübertragungssystems gemäß einem Ausführungsbeispiel.

Fig. 3   die Schritte zum Ermitteln der Kanalkoeffizienten einer hypothetischen Kanalfolge für ein Verfahren gemäß einem Ausführungsbeispiel.

Fig. 4   ein Datenübertragungssystem gemäß einem Ausführungsbeispiel.

Fig. 5   einen unbemannten Flugkörper gemäß einem Ausführungsbeispiel.

Die Darstellungen in den Zeichnungen sind schematisch und nicht maßstabsgetreu. Werden gleiche Bezugsziffern verwendet, so betreffen diese gleiche oder ähnliche Elemente.

**Detaillierte Beschreibung der Ausführungsbeispiele**

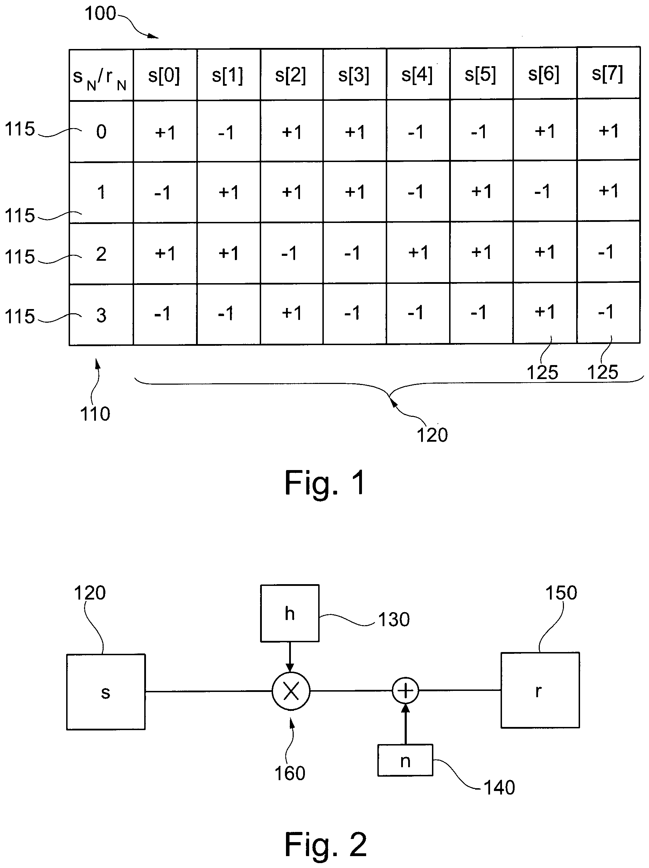

Fig. 1 zeigt eine Zuordnungstabelle 100, welche jedem Symbol 115 eines Alphabet 110 von zulässigen Symbolen 115, für die die Werte 0, 1, 2, 3 beispielhaft angegeben wurden, jeweils eine Sendefolge 120 eineindeutig zuordnet. Jede Sendefolge 120 besteht jeweils aus mehreren Informationseinheiten 125, in diesem Beispiel aus acht Informationseinheiten s[0] bis s[7].

Die Sendefolge 120 wird von dem Sender basierend auf dem zu übertragenden Symbol ermittelt und an den Empfänger übertragen, wobei die Sendefolge aus Sicht des Empfängers mit Störeinflüssen überlagert empfangen wird und als empfangene Zeichenfolge den Ausgangspunkt für die Ausführung des Verfahrens zur Ermittlung der Auswahlmetrik darstellt.

In dem gewählten Beispiel kann jede Informationseinheit s[0] ... s[7] zwei Zustände +1 und -1 einnehmen, so dass mit acht Informationseinheiten 256 verschiedene Zeichenfolgen 120 gebildet werden können.

Die Hamming-Distanz zwischen der Sendefolge für das Symbol "0" und der Sendefolge für das Symbol "1" beträgt vier, da sich diese Sendefolgen in dem Wert für die Informationseinheiten s[0], s[1], s[5] und s[6] unterscheiden und in den Werten der übrigen Informationseinheiten übereinstimmen.

In einem Ausführungsbeispiel wird für jede zulässige Zeichenfolge zunächst die differentiell decodierte Zeichenfolge ermittelt. Die differentiell decodierte Zeichenfolge für die Symbole "0" und "1" aus Fig. 1 stellt sich wie folgt dar:

0: -1; -1; +1; -1; +1; -1; +1.
1: -1; +1; +1; -1; -1; -1; -1.

Ein Koeffizient der differentiell decodierten Zeichenfolge berechnet sich allgemein als Produkt der hypothetischen Zeichenfolge s[k] und s*[k+1]; demnach besteht die differentiell decodierte Zeichenfolge für eine zulässige Zeichenfolge mit acht Informationseinheiten auch aus lediglich sieben Koeffizienten (mit den Positionswertigkeiten 0 bis 6 von links nach rechts), also einem Koeffizienten weniger.

Nach Ermittlung der differentiell decodierten Zeichenfolgen kann für diese die Hamming-Distanz ermittelt werden, was in dem angeführten Beispiel für die Symbole "0" und "1" drei ist, da sich die differentiell decodierten Zeichenfolgen an den Positionen 1, 4 und 6 unterscheiden. Damit gilt also, dass diejenigen Zeichenfolgen bevorzugt als zulässige Zeichenfolgen ausgewählt werden, deren differentiell decodierte Zeichenfolgen die höchste Hamming-Distanz haben.

Fig. 2 zeigt ein Modell eines Übertragungskanals 160. Auf eine Sendefolge s 120 wird eine Kanalfolge h 130 multiplikativ angewandt und kann den Wert jeder einzelnen Informationseinheit der Sendefolge 120 verändern. Zusätzlich kann noch eine additive Störkomponente n 140 die Sendefolge bei der Übertragung zu der Empfangseinheit beeinflussen, so dass die von der Sendeeinheit s 120 gesendete Sendefolge als durch den Übertragungskanal 160 veränderte empfangen Zeichenfolge r 150 bei einer Empfangseinheit ankommt.

Ein unbekannte und möglicherweise variierende Kanalfolge 130 sowie Störkomponente 140 stellen einen nicht im Voraus zu berücksichtigenden Faktor für die Datenübertragung über den Übertragungskanal 160 dar und können die Daten verfälschen. Das Verfahren wie oben und im Folgenden beschrieben ermöglicht auf der Empfängerseite eine Auswahl einer Zeichenfolge aus dem Zeichenfolgenalphabet trotz Unkenntnis der Kanalfolge 130 und der Störkomponente 140.

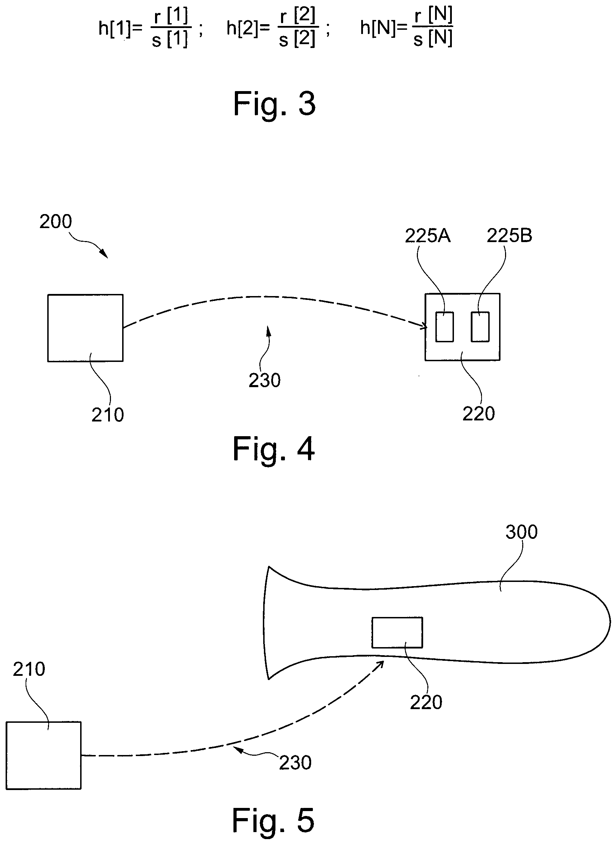

Fig. 3 zeigt die Ermittlung der Kanalkoeffizienten h[1], h[2] und allgemein h[n] einer hypothetischen Kanalfolge $h_N$ basierend auf den Informationseinheiten r[1], r[2] und allgemein r[n] einer empfangenen Zeichenfolge (150) und den Informationseinheiten s[1], s[2] und allgemein s[n] einer zulässigen Zeichenfolge $s_N$ aus dem Zeichenfolgenalphabet. Diese Ermittlung der Kanalkoeffizienten einer hypothetischen Kanalfolge hat mit der empfangenen Zeichenfolge für jede zulässige Zeichenfolge aus dem Zeichenfolgenalphabet zu erfolgen, um dann für jede hypothetische Kanalfolge die Auswahlmetrik zu ermitteln.

Die Auswahlmetrik entspricht der akkumulierten Differenz zwischen jeweils benachbarten Kanalkoeffizienten einer hypothetischen Kanalfolge. Die Differenz zwischen benachbarten Kanalkoeffizienten kann bei reellen Zahlen als Kanalkoeffizienten als Betrag des Abstandes zwischen diesen beiden Kanalkoeffizienten auf einem Zahlenstrahl gesehen werden. Bei Kanalkoeffizienten in Form komplexer Zahlen sind die entsprechenden bekannten Verfahren anzuwenden, die einen Betragsunterschied zwischen zwei komplexen Zahlen angeben.

Beispielhaft soll die Ermittlung der Auswahlmetrik für eine hypothetische Kanalfolge $h_1$ mit folgenden Kanalkoeffizienten gezeigt werden, wobei aus Vereinfachungsgründen lediglich fünf Kanalkoeffizienten dargestellt sind:

$$h_1 : h[0]=2; h[1]=3; h[2]=5; h[3]=7; h[4]=10;$$

Die Auswahlmetrik berechnet sich dann wie folgt:

$$| h[0]-h[1] | + | h[1]-h[2] | + | h[2]-h[3] | + | h[3]-h[4] | = 1 + 2 + 2 + 3 = 8$$

Die einzelnen Summanden der obigen Gleichung können alternativ beispielsweise auch als Quadratzahlen oder höherwertige Potenzen der Differenz benachbarter Kanalkoeffizienten ermittelt werden.

Aus dem Verlauf der Kanalkoeffizienten ist ersichtlich, dass ihr Wert einer regelmäßigen Gesetzmäßigkeit folgt, in diesem Fall gleichmäßig steigt. Diese Metrik deutet grundsätzlich auf eine plausible hypothetische Kanalfolge und somit auf eine plausible zugehörige zulässige Zeichenfolge hin. Die Metrik könnte jedoch niedriger sein, wenn eine andere hypothetische Kanalfolge eine Auswahlmetrik kleiner als 8 aufweist, deren Zeichenfolge dann zu wählen wäre.

Das folgende Beispiel zeigt eine hypothetische Kanalfolge $h_2$ mit unregelmäßig verlaufenden Kanalkoeffizienten $h_2$: h[0]=4; h[1]=1; h[2]=7; h[3]=2; h[4]=11;

Die Auswahlmetrik berechnet sich dann wie folgt:

$$| h[0]-h[1] | + | h[1]-h[2] | + | h[2]-h[3] | + | h[3]-h[4] | = 3 + 6 + 5 + 9 = 23$$

Der hohe Wert für die Auswahlmetrik von 23 deutet auf eine im Vergleich zur hypothetischen Kanalfolge $h_1$ weniger plausible Zeichenfolge hin.

Fig. 4 zeigt ein Datenübertragungssystem 200 mit einer Sendeeinheit 210 und einer Empfangseinheit 220, welche ein erstes Empfangsmodul 225A und ein zweites Empfangsmodul 225B aufweist.

Die Sendeeinheit 210 überträgt Daten über den Übertragungskanal 230 zu jedem der beiden Empfangsmodule 225A, 225B der Empfangseinheit 220, wobei die Empfangsmodule 225A, 225B die übertragenen Daten unabhängig voneinander empfangen.

Bei dem Übertragungskanal 230 handelt es sich in diesem Ausführungsbeispiel um einen Funkkanal.

Fig. 5 zeigt einen unbemannten Flugkörper 300 mit einer Empfangseinheit 220, welche über den Übertragungskanal 230 Daten von einer Sendeeinheit 210 empfängt.

Der unbemannte Flugkörper 300 kann ein Lenkflugkörper sein, welcher sich mit Bezug zu einer stationären Sendeeinheit 210 mit mehreren Tausend Kilometern pro Stunde bewegt, in einem Ausführungsbeispiel bis hin zu dreifacher Schallgeschwindigkeit in der Luft. Durch diese hohe Relativgeschwindigkeit zwischen Sendeeinheit und Empfangseinheit treten neben sonstigen Störeinflüssen auch Störungen durch hohe Dopplerfrequenzen auf.

Das Verfahren wie oben beschrieben ermöglicht auf Seite der Empfangseinheit eine wenig komplexe, wenig rechenaufwändige und zuverlässige Auswahl einer Zeichenfolge aus einem Zeichenfolgenalphabet bei einer Mehrzahl unterschiedlicher und im Voraus unbekannter Störungsquellen und Störeinflüsse auf den Übertragungskanal 230.

Bezugszeichenliste

| | |
|---|---|
| 100 | Zuordnungstabelle |
| 110 | Alphabet |
| 115 | Symbol |
| 120 | Sendefolge |
| 125 | Informationseinheit |
| 130 | Kanalfolge |
| 140 | additiver Übertragungseinfluss |
| 150 | Zeichenfolge |
| 160 | Übertragungskanal (zwischen 120 und 150) |
| 200 | Datenübertragungssystem |
| 210 | Sendeeinheit |
| 220 | Empfangseinheit |
| 225 | Empfangsmodul |
| 230 | Übertragungskanal |
| 300 | unbemannter Flugkörper |

**Patentansprüche**

1. Verfahren zum Ermitteln einer Auswahlmetrik in einem Datenübertragungssystem (200) mit einer Sendeeinheit (210) und einer Empfangseinheit (230), wobei die Auswahlmetrik für eine Auswahl einer Zeichenfolge ($s_N$) aus einer Mehrzahl zulässiger Zeichenfolgen ($s_N$) eines Zeichenfolgenalphabets (110) basierend auf einer über einen Übertragungskanal (160) empfangenen Zeichenfolge (150) vorgesehen ist, und
wobei die Mehrzahl zulässiger Zeichenfolgen ($s_N$) durch ein Zeichenfolgenalphabet (110) vorgegeben ist und jede Zeichenfolge ($s_N$) eine Mehrzahl N von Informationseinheiten (125) aufweist,
das Verfahren aufweisend die Schritte:

   Ermitteln jeweils einer hypothetischen Kanalfolge ($h_N$) in einem Empfangsmodul (225A, 225B) der Empfangseinheit (220), basierend auf der empfangenen Zeichenfolge (150) und jeder Zeichenfolge ($s_N$) der Mehrzahl zulässiger Zeichenfolgen aus dem Zeichenfolgenalphabet (110),
   wobei die hypothetische Kanalfolge ($h_N$) eine Mehrzahl N von hypothetischen Kanalkoeffizienten (h[n], n=1,..,N) aufweist, die jeweils einer Informationseinheit (125) zugeordnet sind,
   Ermitteln der Auswahlmetrik für jede hypothetische Kanalfolge ($h_N$) als Summe der Beträge der Differenz jeweils zweier aufeinanderfolgender hypothetischer Kanalkoeffizienten (h[n], h[n+1]) einer hypothetischen Kanalfolge ($h_N$), in dem Empfangsmodul (225A, 225B),
   Auswählen von Zeichenfolgen aus einer Mehrzahl zulässiger Zeichenfolgen basierend auf Zeichenfolgen der übertragenen Daten und der Auswahlmetriken in der Empfangseinheit (220).

2. Verfahren nach Anspruch 1, wobei die Zeichenfolge ($s_N$) aus der Mehrzahl zulässiger Zeichenfolgen ($s_N$) aus dem Zeichenfolgenalphabet (110) ausgewählt wird, deren Auswahlmetrik den geringsten Betrag aufweist.

3. Verfahren nach einem der vorhergehenden Ansprüche, weiterhin aufweisend den Schritt:
Festlegen der zulässigen Zeichenfolgen ($s_N$) des Zeichenfolgenalphabets (110),
wobei eine Anzahl der zulässigen Zeichenfolgen ($s_N$) kleiner ist als eine Anzahl aller möglichen Zeichenfolgen basierend auf der Mehrzahl N von Informationseinheiten (125) einer Zeichenfolge.

4. Verfahren nach Anspruch 3, wobei die Anzahl der zulässigen Zeichenfolgen ($s_N$) kleiner ist als $2^N$,
wobei $2^N$ der Anzahl aller möglichen Zeichenfolgen bei N Informationseinheiten (125) entspricht, wenn jede Informationseinheit zwei Zustände einnehmen kann.

5. Verfahren nach einem der Ansprüche 3 oder 4, wobei die Anzahl der zulässigen Zeichenfolgen ($s_N$) kleiner ist als die Hälfte der Anzahl aller möglichen Zeichenfolgen.

6. Datenübertragungssystem (200), aufweisend:

   eine Sendeeinheit (210), und
   eine Empfangseinheit (220) mit einem ersten Empfangsmodul (225A),
   wobei die Sendeeinheit (210) ausgeführt ist, Daten über einen Übertragungskanal (230) mit unbekannten Übertragungseigenschaften an die Empfangseinheit (230) zu übertragen,
   wobei das erste Empfangsmodul (225A) ausgeführt ist, das Verfahren nach einem der Ansprüche 1 bis 5 auszuführen.

7. Datenübertragungssystem (200) nach Anspruch 6, wobei die Empfangseinheit (220) ein zweites Empfangsmodul (225B) aufweist, wobei das zweite Empfangsmodul (225B) ausgeführt ist, das Verfahren nach einem der Ansprüche 1 bis 5 auszuführen,
wobei die Empfangseinheit (220) ausgeführt ist, diejenige Zeichenfolge auszuwählen, deren Auswahlmetrik den niedrigsten Betrag hat.

8. Datenübertragungssystem (200) nach Anspruch 7, wobei zwischen der Sendeeinheit (210) und der Empfangseinheit (220) eine Relativbewegung stattfindet.

9. Unbemannter Flugkörper (300), aufweisend:

   eine Empfangseinheit (220), welche ausgeführt ist, über einen Übertragungskanal (230) Daten von einer Sendeeinheit (210) zu empfangen,

wobei die Empfangseinheit (220) ausgeführt ist, das Verfahren nach einem der Ansprüche 1 bis 5 auszuführen.

**Claims**

1. Method for determining a selection metric in a data transmission system (200) comprising a transmission unit (210) and a receiving unit (230), the selection metric being provided for selecting a character sequence ($s_N$) from a plurality of admissible character sequences ($s_N$) of a character sequence alphabet (110) on the basis of a character sequence (150) received via a transmission channel (160), and

   the plurality of admissible character sequences ($s_N$) being specified by a character sequence alphabet (110) and each character sequence ($s_N$) having a plurality N of information units (125),
   the method having the steps of:

   in each case determining a hypothetic channel sequence ($h_N$) in a receiving module (225A, 225B) of the receiving unit (220), on the basis of the received character sequence (150) and of each character sequence ($s_N$) of the plurality of admissible character sequences from the character sequence alphabet (110),
   the hypothetic channel sequence ($h_N$) having a plurality N of hypothetical channel coefficients (h[n], n = 1, ..., N) which are each assigned to an information unit (125),
   determining, in the receiving module (225A, 225B), the selection metric for each hypothetical channel sequence ($h_N$) as the sum of the magnitudes of the differences between every two consecutive hypothetical channel coefficients (h[n], h[n+1]) of a hypothetical channel sequence ($h_N$), selecting character sequences from the plurality of admissible character sequences on the basis of character sequences of the transmitted data and the selection metrics in the receiving unit (220).

2. Method according to claim 1,
   wherein the character sequence ($s_N$) of which the selection metric has the smallest magnitude is selected from the plurality of admissible character sequences ($s_N$) from the character sequence alphabet (110).

3. Method according to any of the preceding cflaims, further comprising the step of:

   establishing the admissible character sequence ($s_N$) of the character sequence alphabet (110),
   the number of admissible character sequences ($s_N$) being smaller than the number of all possible character sequences on the basis of the plurality N of information units (125) of a character sequence.

4. Method according to claim 3,
   wherein the number of admissible character sequences ($s_N$) is less than $2^N$,
   where $2^N$ corresponds to the number of all possible sequences for N information units (125) if each information unit can take on two states.

5. Method according to either claim 3 or claim 4,
   wherein the number of the admissible character sequences ($s_N$) is less than half of the number of all possible character sequences.

6. Data transmission system (200), having:

   a transmission unit (210) and
   a receiving unit (220) comprising a first receiving module (225A),
   wherein the transmission unit (210) is configured to transmit data to the receiving unit (230) via a transmission channel (230) having unknown transmission properties,
   wherein the first receiving module (225A) is configured to carry out the method according to any of claims 1 to 5.

7. Data transmission system (200) according to claim 6,
   wherein the receiving unit (220) has a second receiving module (225B),
   wherein the second receiving module (225B) is configured to carry out the method according to any of claims 1 to 5, wherein the receiving unit (220) is configured to select the character sequence of which the selection metric has the smallest magnitude.

8. Data transmission system (200) according to claim 7,

wherein a relative movement takes place between the transmission unit (210) and the receiving unit (220).

9. Unmanned missile (300), having:

a receiving unit (220) which is configured to receive data from a transmission unit (210) via a transmission channel (230),
wherein the receiving unit (220) is configured to carry out the method according to any of claims 1 to 5.

**Revendications**

1. Procédé de détermination d'une métrique de sélection dans un système de transmission de données (200) avec une unité d'émission (210) et une unité de réception (230), la métrique de sélection étant prévue pour une sélection d'une chaîne de caractères ($S_N$) à partir d'une pluralité de chaînes de caractères ($S_N$) admissibles d'un alphabet de chaînes de caractères (110) sur la base d'une chaîne de caractères (150) reçue par le biais d'un canal de transmission (160), et
la pluralité de chaînes de caractères ($S_N$) admissibles étant prescrite par un alphabet de chaînes de caractères (110), et chaque chaîne de caractères ($S_N$) comportant une pluralité N d'unités d'information (125),
le procédé comportant les étapes suivantes :

détermination respectivement d'une séquence de canaux ($h_N$) hypothétique dans un module de réception (225A, 225B) de l'unité de réception (220), sur la base de la chaîne de caractères (150) reçue et de chaque chaîne de caractères ($S_N$) de la pluralité de chaînes de caractères admissibles à partir de l'alphabet de chaînes de caractères (110),
la séquence de canaux ($h_N$) hypothétique comportant une pluralité N de coefficients de canaux (h[n], n=1,...,N) hypothétiques qui sont affectés respectivement à une unité d'information (125),
détermination de la métrique de sélection pour chaque séquence de canaux ($h_N$) hypothétique en tant que somme des montants de la différence respectivement de deux coefficients de canaux (h[n],h[n=l]) hypothétiques successifs d'une séquence de canaux ($h_N$) hypothétique, dans le module de réception (225A, 225B),
sélection de chaînes de caractères à partir d'une pluralité de chaînes de caractères admissibles sur la base de chaînes de caractères des données transmises et des métriques de sélection dans l'unité de réception (220).

2. Procédé selon la revendication 1,
la chaîne de caractères ($S_N$) étant sélectionnée à partir de la pluralité de chaînes de caractères ($S_N$) admissibles,
à partir de l'alphabet de chaînes de caractères (110), dont la métrique de sélection présente le montant le plus faible.

3. Procédé selon l'une des revendications précédentes, comportant également l'étape suivante :

fixation des chaînes de caractères ($S_N$) admissibles de l'alphabet de chaînes de caractères (110),
un nombre des chaînes de caractères ($S_N$) admissibles étant plus petit qu'un nombre de toutes les chaînes de caractères possibles sur la base de la pluralité N d'unités d'information (125) d'une chaîne de caractères.

4. Procédé selon la revendication 3,
le nombre de chaînes de caractères ($S_N$) admissibles étant inférieur à $2^N$,
$2^N$ correspondant au nombre de toutes les chaînes de caractères possibles pour N unités d'information (125) quand chaque unité d'information peut adopter deux états.

5. Procédé selon l'une des revendications 3 ou 4,
le nombre de chaînes de caractères ($S_N$) admissibles étant inférieur à la moitié du nombre de toutes les chaînes de caractères possibles.

6. Système de transmission de données (200), présentant :

une unité d'émission (210), et
une unité de réception (220) avec un premier module de réception (225A),
l'unité d'émission (210) étant réalisée pour transmettre à l'unité de réception (230) des données par le biais d'un canal de transmission (230) avec des caractéristiques de transmission inconnues,
le premier module de réception (225A) étant réalisé pour réaliser le procédé selon l'une des revendications 1 à 5.

7. Système de transmission de données (200) selon la revendication 6,
l'unité de réception (220) comportant un deuxième module de réception (225B),
le deuxième module de réception (225B) étant réalisé pour réaliser le procédé selon l'une des revendications 1 à 5, l'unité de réception (220) étant réalisée pour sélectionner la chaîne de caractères dont la métrique de sélection a le montant le plus faible.

8. Système de transmission de données (200) selon la revendication 7,
un mouvement relatif survenant entre l'unité d'émission (210) et l'unité de réception (220).

9. Missile (300) sans pilote, comportant :

une unité de réception (220) qui est réalisée pour recevoir, par le biais d'un canal de transmission (230), des données d'une unité d'émission (210),
l'unité de réception (220) étant réalisée pour réaliser le procédé selon l'une des revendications 1 à 5.

100

| $s_N/r_N$ | s[0] | s[1] | s[2] | s[3] | s[4] | s[5] | s[6] | s[7] |
|---|---|---|---|---|---|---|---|---|
| 0 | +1 | -1 | +1 | +1 | -1 | -1 | +1 | +1 |
| 1 | -1 | +1 | +1 | +1 | -1 | +1 | -1 | +1 |
| 2 | +1 | +1 | -1 | -1 | +1 | +1 | +1 | -1 |
| 3 | -1 | -1 | +1 | -1 | -1 | -1 | +1 | -1 |

115
115
115
115

125 125

110

120

## Fig. 1

120

150

130

h

s

r

⊗

⊕

n

160

140

## Fig. 2

$$h[1]= \frac{r\,[1]}{s\,[1]}\;; \quad h[2]= \frac{r\,[2]}{s\,[2]}\;; \quad h[N]= \frac{r\,[N]}{s\,[N]}$$

## Fig. 3

Fig. 4

Fig. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 2296288 B1
- US 20040066865 A1
- US 2003099308 A1

### In der Beschreibung aufgeführte Nicht-Patentliteratur

- Radar-Sonar Signal Processing and Gaussian Signals in Noise. **VAN TREES.** Detection, Estimation, and Modulation Theory. John Wiley & Sons, 2004